(19) Europäisches Patentamt
European Patent Office
Office européen des brevets

(11) **EP 1 597 597 B1**

(12) **FASCICULE DE BREVET EUROPEEN**

(45) Date de publication et mention
de la délivrance du brevet:
**25.04.2007 Bulletin 2007/17**

(51) Int Cl.:
***G01R 15/18*** *(2006.01)*

(21) Numéro de dépôt: **04713954.8**

(22) Date de dépôt: **24.02.2004**

(86) Numéro de dépôt international:
**PCT/IB2004/000569**

(87) Numéro de publication internationale:
**WO 2004/077077 (10.09.2004 Gazette 2004/37)**

(54) **PROCEDE POUR MESURER L'INTENSITE DU COURANT CONSOMME PAR UN RADIATEUR ELECTRIQUE D'UN APPAREIL DE VENTILATION DE CHAUFFA GE ET/OU DE CLIMATISATION DE VEHICULE**

VERFAHREN ZUR MESSUNG DER STROMAUFNAHME EINES ELEKTRISCHEN KÜHLERS IN EINEM FAHRZEUGBELÜFTUNGS-, HEIZ- ODER KLIMAANLAGENSYSTEM

METHOD FOR MEASURING THE CURRENT CONSUMPTION OF AN ELECTRIC RADIATOR IN A VEHICLE VENTILATION, HEATING OR AIR CONDITIONING SYSTEM

(84) Etats contractants désignés:
**AT BE BG CH CY CZ DE DK EE ES FI FR GB GR HU IE IT LI LU MC NL PT RO SE SI SK TR**

(30) Priorité: **27.02.2003 FR 0302399**

(43) Date de publication de la demande:
**23.11.2005 Bulletin 2005/47**

(73) Titulaire: **VALEO SYSTEMES THERMIQUES**
**78321 Le Mesnil Saint Denis (FR)**

(72) Inventeur: **MARANGE, Christophe**
**F-78400 Chatou (FR)**

(56) Documents cités:
**DE-A- 10 061 458          FR-A- 2 546 304**
**US-B1- 6 479 976**

• **PATENT ABSTRACTS OF JAPAN vol. 1996, no. 11, 29 novembre 1996 (1996-11-29) & JP 08 179002 A (NIPPON INTER ELECTRONICS CORP), 12 juillet 1996 (1996-07-12)**

## Description

L'invention se rapporte à un procédé pour mesurer l'intensité du courant consommé par un radiateur électrique d'un appareil de ventilation, de chauffage et/ou de climatisation de véhicule.

Actuellement, certains organes électriques de chauffage pour appareil de ventilation, de chauffage et/ou de climatisation d'habitacle de véhicule automobile, tel que des radiateurs électriques, sont pourvus de moyens de mesure de consommation du courant utilisé par chacun de leurs éléments chauffants, appelés également phases. Ces moyens sont notamment utiles pour la gestion de l'énergie du véhicule. La précision de la mesure est donc importante pour fournir une information en retour qui est représentative du fonctionnement du radiateur.

Parmi les techniques utilisées, on peut citer le document DE 100 61 458 ou l'utilisation d'un transistor qui inclut dans ses fonctionnalités la possibilité d'indiquer directement l'intensité du courant qui le traverse, et donc le courant consommé par le radiateur. Le transistor est soit placé dans le flux d'air, proche des éléments chauffants, soit en dehors du flux d'air, par exemple proche d'un circuit de commande du radiateur. Il est également possible d'utiliser un élément de mesure ajouté directement à la source de courant. Dans ces deux cas, un micro-contrôleur est utilisé pour sommer la consommation de chaque élément chauffant afin de déduire la consommation totale du courant du radiateur.

Cependant, ces techniques présentent des limitations et des inconvénients. D'abord, la précision des mesures est faible, à moins de prévoir une phase d'étalonnage au moment de la fabrication du produit, celui-ci ne fournissant pas, généralement, de résultats suffisamment fiables dans le temps. Le coût est également prohibitif dans certains cas, notamment par l'utilisation d'un transistor incluant dans ses fonctionnalités la possibilité d'indiquer directement l'intensité.

Pour résoudre ces problèmes, l'invention propose d'intégrer un capteur dans l'organe de chauffage électrique de manière non intrusive, sans placer ledit capteur en série avec le courant qui est mesuré, et donc sans dissipation de puissance ni perte de courant.

Plus précisément, l'invention se rapporte à un procédé pour mesurer l'intensité totale du courant consommé par au moins un élément chauffant d'un radiateur électrique d'un appareil de ventilation, de chauffage et/ou de climatisation pour habitacle de véhicule automobile, caractérisé en ce qu'il comprend les étapes suivantes :

a) alimenter en courant ledit au moins élément chauffant pour le faire fonctionner au maximum de sa puissance en allumant un interrupteur,
b) couper l'alimentation électrique dudit au moins un élément chauffant mis en route à l'étape a) en éteignant l'interrupteur,
c) alimenter électriquement de nouveau ledit au moins un élément chauffant et mesurer une grandeur physique électrique dudit élément chauffant liée directement ou indirectement à l'intensité totale du courant consommé par cet élément chauffant.

Selon un premier mode de réalisation de l'invention, à l'étape c), la mesure de la grandeur électrique est une mesure de l'intensité du courant consommé par l'élément chauffant réalisée en plaçant un tore magnétique autour de la prise d'alimentation dudit élément chauffant, et en mesurant l'intensité du courant induit créé par ledit tore lorsqu'il est traversé par le courant consommé par l'élément chauffant.

Avantageusement, un flux d'air arrivant dans l'élément chauffant pour le traverser afin d'y être réchauffé, le tore est dimensionné de manière à pouvoir mesurer une intensité du courant circulant dans l'élément chauffant correspondant à une température minimale du flux d'air et un débit d'air maximal.

De préférence, :

à l'étape a), les éléments chauffants sont alimentés successivement en courant en allumant l'interrupteur,
à l'étape b), l'alimentation électrique de tous les éléments chauffants allumés à l'étape a) est coupée en éteignant l'interrupteur, pour décharger l'énergie stockée par le tore,
à l'étape c), chaque élément chauffant est alimenté de nouveau en courant en allumant l'interrupteur, et l'intensité du courant induit créé par le tore est mesurée puis filtrée et amplifiée afin d'être traitée dans un micro-contrôleur,
à l'étape d), les étapes a) à c) sont réitérées successivement avec le même tore placé à une entrée commune de tous les éléments chauffants, et
à l'étape e), la somme des intensités du courant induit créé par le tore pour chaque élément chauffant est calculée par le micro-contrôleur pour déterminer l'intensité totale du courant consommé par le radiateur électrique.

Selon un autre mode de réalisation de l'invention :

- à l'étape a), des éléments chauffants du radiateur électrique sont alimentés à l'aide d'une source de courant dédiée individuellement à chaque élément chauffant et dont l'intensité est connue et la tension est mesurée en continue, de manière à déterminer la résistance électrique de chaque élément chauffant, à l'aide de la relation du type U=R x I,
- à l'étape b), l'alimentation d'au moins un élément chauffant est coupée,
- à l'étape c), ledit au moins un élément chauffant coupé à l'étape b) est de nouveau alimenté à l'aide de la source, et l'intensité du courant consommé par chaque élément chauffant est calculé à l'aide de la relation du type U=R x I,

- à l'étape d), on réitère les étapes a) à c) successivement pour tous les éléments chauffants est successivement alimenté, à l'étape c), et
- à l'étape e), la somme des intensités calculées est effectuée afin d'obtenir l'intensité totale du courant consommé par le radiateur électrique.

Avantageusement, à l'étape d), le ou les élément(s) allumés(s) à l'étape c) reste(nt) allumé(s) lors de l'allumage d'un autre élément.

D'autres caractéristiques, détails et avantages de l'invention ressortiront à la lecture de la description faite en référence aux dessins annexés donnés à titre d'exemple qui représentent respectivement :

- la figure 1, une vue schématique d'un radiateur électrique de chauffage pour appareil de ventilation, de chauffage et/ou de ventilation d'habitacle de véhicule automobile selon la présente invention,
- la figure 2, une vue en coupe du câble d'alimentation du radiateur,
- la figure 3, une vue schématique représentant l'intensité du courant circulant dans un tore magnétique monté autour d'une prise d'alimentation du radiateur et faisant office de capteur de mesure,
- la figure 4, une vue schématique d'un deuxième mode de réalisation d'un radiateur électrique conforme à l'invention,

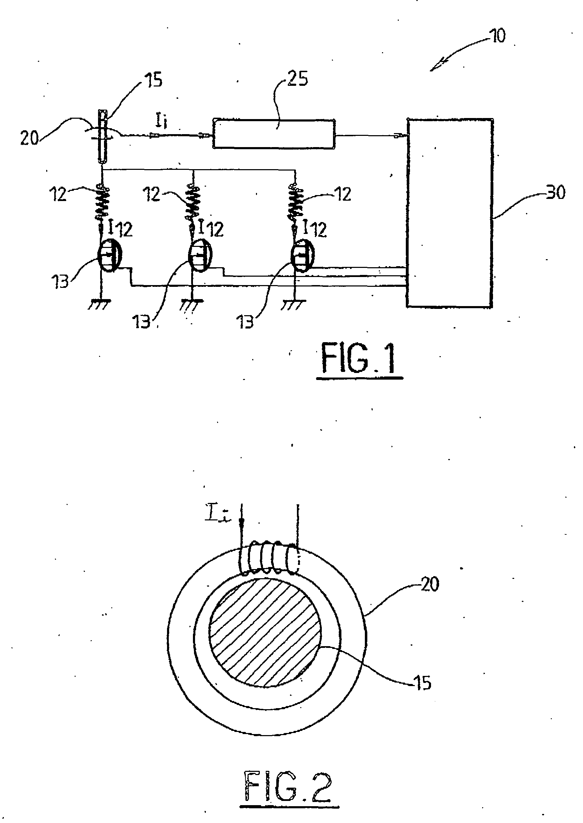

La figure 1 représente un schéma électrique d'un radiateur électrique de chauffage 10 appartenant de manière plus globale à un appareil de ventilation, de chauffage et/ou de climatisation (non représenté) pour véhicule automobile.

Ce radiateur 10 est constitué par une pluralité d'éléments de chauffage 12, trois dans le cas présent, montés électriquement en parallèles. Typiquement, chaque élément chauffant 12 fonctionne comme une résistance électrique à coefficient de température positif (CTP), c'est-à-dire comme une résistance dont la résistance électrique augmente en fonction de la température de chauffage atteinte. Chaque élément chauffant 12 est relié électriquement à un interrupteur 13 relié à la masse et à une source de courant dont l'intensité est parfaitement connue. Une prise 15 d'alimentation est prévue sur le radiateur 10 et agencée électriquement de manière commune à tous les éléments chauffants 12, comme cela est schématisé. La tension de cette deuxième source de courant est connue, par exemple fixée à 12 Volts. Un tore magnétique 20 est disposé autour de la prise d'alimentation 15, comme cela est également illustré plus en détail sur la figure 2 qui est une vue en coupe de la prise d'alimentation 15 et du tore 20. Un circuit de traitement analogique 25 et un micro-contrôleur 30 sont montés en sortie du tore magnétique 20 pour récupérer un courant induit créé par ledit tore 20, comme cela est expliqué ci-après.

Le procédé utilisé pour déterminer le courant total $I_t$ consommé par le radiateur électrique 10, c'est-à-dire le courant consommé par tous ses éléments chauffants 12 alimentés en pleine charge, est le suivant :

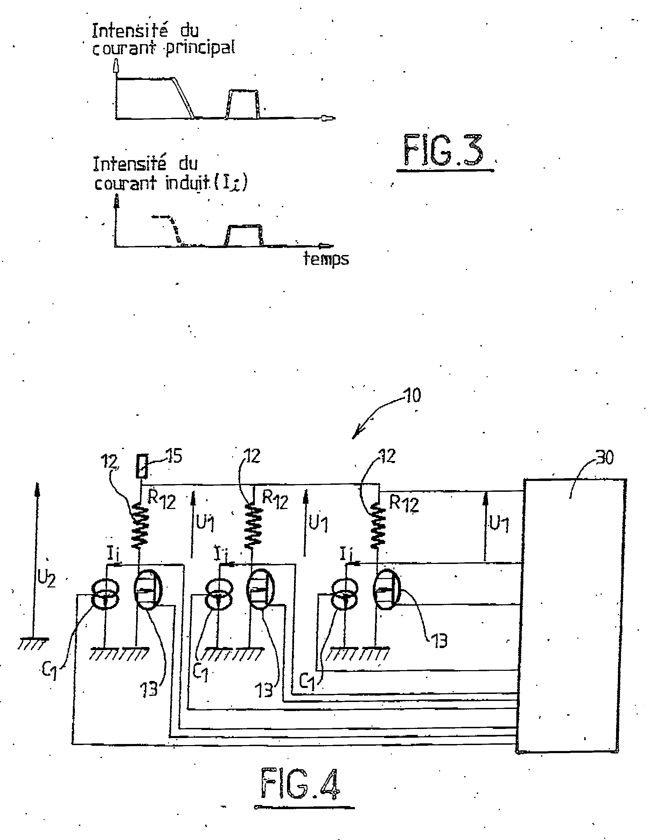

Dans un premier temps, au moins un élément chauffant 12 est mis en route à pleine puissance en allumant l'interrupteur 13 correspondant. Comme cela est indiqué sur la figure 3, la courbe du haut illustre l'application du premier courant à l'élément chauffant.

Ensuite, tous les éléments chauffants allumés à l'étape précédente sont éteints en éteignant l'interrupteur 13 afin de décharger le tore 20 en énergie, comme illustré par les traits en pointillés du schéma du bas de la figure 3.

Un élément chauffant 12 venant d'être allumé puis éteint est alors alimenté de nouveau en courant en allumant l'interrupteur 13 correspondant, toujours à pleine puissance.

Un courant principal circule donc au travers de la prise d'alimentation 15, et le tore 20 étant magnétique, ce courant principal créé un courant $I_i$ induit. Le courant induit $I_i$ est récupéré puis est filtré et amplifié par le circuit de traitement analogique 25. En particulier, le circuit de traitement 25 permet de mesurer le pic de courant $I_i$ mesuré, comme illustré par le schéma du bas de la figure 3. L'augmentation du courant induit mesuré, c'est-à-dire le pic affiché, est fonction du courant circulant dans la prise d'alimentation 15. La mesure est effectuée pendant un court intervalle de temps de manière à obtenir un courant induit, la valeur finale de la mesure donne une image du courant $I_{12}$ consommé par ledit élément chauffant 12, le champ magnétique circulant dans le tore étant fonction du courant principal. Si l'amplitude du champ magnétique monte trop haut, le tore 20 peut saturer, ce qui conduit à une mesure invalide. C'est la raison pour laquelle pendant la mesure, le courant doit être limité, par exemple à 30 A. cette limitation de courant peut cependant être augmentée en augmentant la taille du tore pour éviter la saturation. En pratique, comme il est préférable de réduire les dimensions du tore pour des questions d'encombrement, le tore 20 est dimensionné de manière à pouvoir mesurer une intensité $I_{12}$ du courant circulant dans l'élément chauffant 12 correspondant à une température minimale du flux d'air et un débit d'air maximal traversant ledit élément chauffant 12 considéré.

Chaque élément chauffant 12 qui n'a pas été allumé après avoir été éteint est ensuite successivement alimenté de nouveau en courant en allumant l'interrupteur 13 correspondant, et chaque courant induit $I_i$ créé par le tore est mesuré, puis traité.

Au final, le micro-contrôleur 30 additionne, après filtrage et amplification par le circuit de traitement analogique 25, l'intensité $I_i$ de tous les courants induits créés lors de l'alimentation de chaque élément chauffant 12, afin de déterminer l'intensité finale $I_t$ du courant consommé par le radiateur 10 lorsqu'il fonctionne à pleine charge.

La figure 4 illustre un deuxième mode de réalisation de l'invention permettant de mesurer également l'intensité totale $I_t$ du courant consommé par un radiateur électrique d'un appareil de ventilation, de chauffage et/ou de climatisation de véhicule automobile.

Le radiateur électrique 10 comporte également trois éléments chauffants 12 montés en parallèle. Chaque élément chauffant 12 est relié à une première source de courant C1 et un interrupteur 13 qui lui sont propres. Un circuit de traitement 25 et micro-contrôleur 30 sont également prévus.

Le procédé utilisé pour mesuré le courant $I_t$ consommé par le radiateur 10 est le suivant :

La première source de courant C1, dont l'intensité I1 est connue et dont la tension U1 est mesurée avec précision, circule dans un des éléments chauffants 12 du radiateur 10 en positionnant l'interrupteur 13 correspondant dans la position appropriée. La résistance électrique $R_{12}$ de l'élément chauffant 12 est alors déterminée à l'aide de la relation U1=$R_{12}$ x I1.

L'élément chauffant 12 étant considéré comme une résistance à coefficient de température positif (CTP), sa valeur de résistance électrique évolue en augmentant avec la température. Comme les éléments chauffants sont le plus souvent empilés verticalement les uns au-dessus des autres dans la veine d'air pour former le radiateur 10, certains éléments, même dans le cas où ils sont tous strictement identiques structurellement parlant, ne chauffent pas exactement de la même façon entre le haut et le bas de la veine d'air. La température atteinte dans chaque élément chauffant peut ainsi varier de quelques dixièmes de degré à quelques degrés, modifiant ainsi la valeur de la résistance électrique $R_{12}$. Ainsi, il convient de mesure la résistance électrique de manière précise pour chaque élément chauffant 12. Pour cela, chaque élément chauffant est alimenté successivement par une source individuelle de courant C1. Afin d'avoir une mesure finale précise, l'étape de mesure de la résistance électrique R12 est donc effectuée pour chaque élément chauffant 12.

Une fois la valeur de la résistance électrique $R_{12}$ de chaque élément chauffant 12 obtenue, les éléments chauffants 12 sont alors de préférence tous éteints, bien que cela ne soit pas obligatoire.

Ensuite, chaque élément chauffant 12 est successivement alimenté de nouveau en courant en allumant l'interrupteur 13 correspondant mais avec une source de courant dont la tension d'alimentation U2 est connue (variable du système mesurée en permanence). En utilisant la relation U2=$R_{12}$ x $I_{12}$, il est ainsi possible de calculer l'intensité $I_{12}$ du courant qui circule dans l'élément chauffant 12 et correspond au courant consommé par ledit élément chauffant, à l'aide de la formule suivante :

$$I_{12} = (U2/U1) \times I1$$

Cette opération est réitérée pour chaque élément chauffant 12 afin de connaître l'intensité du courant consommé par chacun d'entre eux.

Enfin, la somme des intensités $I_{12}$ est déterminée par le micro-contrôleur 30 de manière à connaître l'intensité totale $I_t$ du courant consommé par le radiateur 10.

Il est intéressant de noter qu'il y a différentes variantes de réalisation concernant ce mode de fonctionnement. En effet, il est possible d'allumer tous les éléments chauffants dans la première étape, d'en éteindre seulement un certain nombre dans la seconde étape, par exemple deux sur trois, et d'en rallumer un seul parmi ceux qui ont été éteints. Ceci n'a pas d'influence sur la mesure finale en raison du montage en parallèle et du fait que la résistance R12 de chaque élément est parfaitement déterminée

Les avantages de la solution de la présente invention sont les suivants :

- Système de mesure non intrusif,
- mesure très fiable et précise (mois de 5% d'incertitude),
- mesure du courant sans perte de puissance,
- très peu de composants et faible encombrement.

Il doit être bien entendu toutefois que ces exemples sont donnés uniquement à titre d'illustration de l'objet de l'Invention dont ils ne constituent en aucune manière une limitation.

## Revendications

1. Procédé pour mesurer l'intensité du courant total $I_t$ consommé par un radiateur électrique (10) d'un appareil de ventilation, de chauffage et/ou de climatisation pour habitacle de véhicule automobile, ledit radiateur étant constitué par des éléments chauffants (12) reliés chacun à un interrupteur (13) et comportant un tore magnétique (20) disposé autour d'une prise d'alimentation (15) commune aux éléments chauffants (12), **caractérisé en ce que** :

   - à l'étape a), un ou plusieurs éléments chauffants (12) sont alimentés en courant en allumant l'interrupteur (13),
   - à l'étape b), l'alimentation électrique de tous les éléments chauffants (12) allumés à l'étape a) est coupée en éteignant l'interrupteur (13), pour décharger l'énergie stockée par le tore magnétique (20),
   - à l'étape c), un élément chauffant (12) est alimenté de nouveau en courant en allumant l'interrupteur (13), l'intensité $I_i$ du courant induit créé par le tore magnétique (20) lorsqu'il est traversé par le courant consommé par l'élément chauffant (12) est mesurée puis filtrée et amplifiée afin d'être traitée dans un micro-contrôleur de sorte à mesurer l'intensité $I_{12}$ du courant consommé par l'élément chauffant (12),

- à l'étape d), les étapes a) à c) sont réitérées successivement avec le tore (20) et chaque élément chauffant (12) qui n'a pas été allumé après avoir été éteint est ensuite successivement alimenté de nouveau en courant en allumant l'interrupteur (13) correspondant,

- à l'étape e), la somme des intensités $I_i$ du courant induit pour chaque élément chauffant (12) est calculée par un micro-contrôleur (30) pour déterminer l'intensité totale $I_t$ du courant consommé par le radiateur électrique (10).

**2.** Procédé selon la revendication 1, **caractérisé en ce qu'**un flux d'air arrivant dans l'élément chauffant (12) pour le traverser afin d'y être réchauffé, le tore magnétique (20) est dimensionné de manière à pouvoir mesurer une intensité du courant circulant dans l'élément chauffant (12) correspondant à une température minimale du flux d'air et un débit d'air maximal.

## Claims

**1.** Process for measuring the intensity of the total current $I_t$ consumed by an electric radiator (10) of a ventilation, heating and/or air conditioning device for the cabin of an automobile vehicle, wherein said radiator is constituted by heating elements (12) each connected to a switch (13) and comprising a magnetic torus (20) positioned around a power socket (15) that is common to the heating elements (12); **characterised in that**:

- in step a), one or more heating elements (12) are powered by a current'when the switch (13) is switched on,
- in step b), the electrical power supply of all the heating elements (12) switched on in step a) is cut off when the switch (13) is turned off to discharge the energy stored by the magnetic torus (20),
- in step c), one heating element (12) is again powered by a current by switching on the switch (13), the intensity $I_i$ of the induced current created by the magnetic torus (20) when the current consumed by the heating element (12) passes through it is measured and then filtered and amplified so as to be processed in a micro-controller so that the intensity $I_{12}$ of the current consumed by the heating element (12) can be measured,
- in step d), steps a) to c) are repeated successively with the torus (20), and each heating element (12) that has not been switched on after having been switched off is then successively powered again by a current by switching on the corresponding switch (13),
- in step e), the sum of the intensities $I_i$ of the current induced for each heating element (12) is calculated by a micro-controller (30) in order to determine the total intensity $I_t$ of the current consumed by the electric radiator (10).

**2.** Process of claim 1, **characterised in that** an air flow enters the heating element (12) to pass through it in order to be heated, the magnetic torus (20) is sized so that it can measure an intensity of the current circulating in the heating element (12) corresponding to a minimum temperature of the air flow and a maximum flow rate of air.

## Patentansprüche

**1.** Verfahren zur Messung der gesamten Stromstärke $I_t$, welcher Strom von einem elektrischen Heizkörper (10) einer Belüftungs-, Heizungs- und/oder Klimaanlage für den Insassenraum eines Automobils verbraucht wird, wobei der besagte Heizkörper aus Heizelementen (12) besteht, die jeweils an einen Schalter (13) angeschlossen sind und einen Magnetkern (20) aufweisen, welcher um eine den Heizelementen (12) gemeinsame Steckdose (15) herum angeordnet ist, **dadurch gekennzeichnet, dass**

- bei Schritt a) ein oder mehrere Heizelemente (12) durch Einschalten des Schalters (13) mit Strom versorgt werden,
- bei Schritt b) die Stromversorgung aller in Schritt a) eingeschalteten Heizelemente (12) durch Ausschalten des Schalters (13) unterbrochen wird, um die von dem Magnetkern (20)gespeicherten Energie abzuladen,
- bei Schritt c) ein Heizelement (12) erneut durch Einschalten des Schalters (13) mit Strom versorgt wird, die Stromstärke $I_i$ des von dem Magnetkern (20)erzeugten Nebenstroms, wenn er von den Heizelementen (12) verbrauchten Strom durchquert wird, erst gemessen wird, dann gefiltert und verstärkt wird, um in einem Mikrokontroller so verarbeitet zu werden, dass die Stromstärke $I_{12}$ des von dem Heizelement (12) verbrauchten Stromes gemessen wird,
- bei Schritt d) die Schritte a) bis c) mit dem Magnetkern (20) nacheinander wiederholt werden, und dass jedes Heizelement (12), das nach Abschalten nicht wieder eingeschaltet worden ist, nacheinander mit Strom versorgt wird, indem der entsprechende Schalter (13) eingeschaltet wird.

- bei Schritt e) die Summe der Stromstärken $I_i$ des Nebenstromes für jedes Heizelement (12) durch einen Mikrokontroller (30) berechnet wird, um die gesamte Stromstärke $I_t$ des von dem elektrischen Heizkörper (10)verbrauchten Stromes festzustellen.

2. Verfahren nach Anspruch 1, **dadurch gekennzeichnet, dass** ein Luftstrom, der in das Heizelement (12) antrifft, um es zu durchströmen, um dort geheizt zu werden, der Magnetkern (20) so dimensioniert ist, dass er eine in dem Heizelement (12) fließende Stromstärke messen kann, welche einer Mindesttemperatur des Luftflusses und einem maximalen Luftdurchfluss entspricht.

FIG.1

FIG.2

Intensité du
courant principal

<u>FIG.3</u>

Intensité du
courant induit (I$_i$)

temps

10

12    15       12              12                    30

R$_{12}$    U$_1$   R$_{12}$   U$_1$   R$_{12}$   U$_1$

I$_i$        I$_i$       I$_i$

U$_2$

C$_1$      13       C$_1$   13     C$_1$         13

<u>FIG.4</u>

8